Europäisches Patentamt

European Patent Office

Office européen des brevets

(11) Publication number: **0 211 673**
**A2**

# EUROPEAN PATENT APPLICATION

(21) Application number: **86306166.9**

(51) Int. Cl.⁴: **H03M 7/50**

(22) Date of filing: **08.08.86**

(30) Priority: **09.08.85 GB 8520037**

(43) Date of publication of application:
**25.02.87 Bulletin 87/09**

(84) Designated Contracting States:
**BE CH DE FR IT LI NL SE**

(71) Applicant: **PLESSEY OVERSEAS LIMITED**
**Vicarage Lane**
**Ilford Essex IGI 4AQ(GB)**

(72) Inventor: **Hancock, Steven**
**24 Rivercourt Ellington Road**
**Taplow Berkshire(GB)**

(74) Representative: **Sorenti, Gino**
**Intellectual Property Department The**
**Plessey Company plc 2-60 Vicarage Lane**
**Ilford Essex IG1 4AQ(GB)**

(54) **Signal conversion circuits.**

(57) A linear to A-law and A-law to linear pcm-tdm encoding circuit converts two sixteen bit linear encoded pcm-tdm data streams to one eight bit A-law encoded pcm-tdm data stream having twice as many channels and vice-versa. Incoming bit streams constantly step through the circuit with either A-law encoded or linear encoded data being converted to an intermediate code comprising a sign bit, a chord number and step bits prior to conversion to the desired output encoding. Using shift registers and multiplexers addressed by stored chord numbers ensures minimum delay of the data during conversion.

EP 0 211 673 A2

## Signal Conversion Circuits

The present invention relates to signal conversion circuits and more particularly to such circuits for converting linear encoded pulse code modulated (pcm) speech signals to A-law encoded pcm signals and vice versa.

PCM sampling of speech (analogue) signals to convert the signals to digital levels for use in for example, a time division multiplex (TDM) switching system is a well known technique.

It is usually convenient to convert analogue signals on a linear basis using, say, sixteen binary digits representing digital levels at pre-determined sampling times. However, such pcm systems require a high data throughput which effectively reduces the number of channels which may be time division multiplexed on a given highway. One internationally recognized standard for encoding pcm is known as A-law encoding which utilises eight bits rather than the sixteen mentioned above leading to higher channel densities on tdm highways. However, direct conversion from analogue to A-law encoded pcm and vice versa may be a complicated process.

Therefore it is one object of the present invention to provide a signal conversion circuit capable of converting linear encoded pcm signals to A-law encoded pcm signals and vice versa.

According to a first aspect of the present invention there is provided a signal conversion circuit for converting an A-law encoded pcm-tdm data stream to two linear encoded pcm-tdm data streams the circuit comprising inversion means arranged to invert alternate bits of an incoming A-law encoded data stream to provide an intermediate encoded data stream having a sign bit, a plurality of chord bits characterising a chord number and a plurality of step bits, shift register means through which said intermediate encoded data stream is stepped at the bit rate, and a conversion circuit in respect of each linear encoded data stream which are respectively enabled on alternate frames of the incoming data stream and which each comprise storage means and counter means simultaneously enabled to set to the chord number received from predetermined outputs of the shift register means, the counter means counting at the bit rate to address multiplexing means to select for output in dependance upon the chord number and in respect of each frame at least one prefix bit of a first binary value, one bit of a value dependant upon the stored chord number, the plurality of step bits, a bit of the other binary value and a plurality or suffix bits of the first binary value, and inversion means responsive to the sign bit value to pass or invert the output of the multiplexing means.

Preferably said storage means addresses further multiplexing means arranged to select one output of the outputs of the shift register means in dependance upon the stored chord number to provide the plurality of step bits to inputs of the first said multiplexing means.

The storage means may also be arranged to store the sign bit received from another predetermined output of the shift register means.

According to a second aspect of the present invention there is provided a signal conversion circuit for converting two linear encoded pcm-tdm data streams to a single A-law encoded pcm-tdm data stream the circuit comprising two encoders for converting respective linear encoded data streams to an intermediate encoded data stream, multiplexing means for selecting the outputs of the two encoders alternately to provide alternate frames of the output A-law encoded data stream and inversion means responsive to clock signals to invert alternate bits of the intermediate encoded data stream to provide the A-law encoded data stream, each of said two encoders comprising means responsive to a frame synchronisation signal to store for each frame a sign bit from the incoming signal, inversion means responsive to the stored sign bit to invert or pass the incoming signal, counting means arranged to count the number of prefix bits present in the incoming signals and to provide a plurality of chord bits defining a chord number and selection means responsive to the chord number to select the plurality of bits following the prefix bits to output as step bits.

Preferably said selection means comprises a shift register to which the incoming signal is applied, outputs of said shift register being connected to multiplexing means addressed by said chord number such that one output of said shift register provides the step bits to the first said multiplexing means.

In the preferred embodiment of a signal conversion circuit described hereinafter the circuit comprises an A-law to linear conversion circuit in accordance with the first aspect of the present invention and a linear to A-law conversion circuit in accordance with the second aspect of the invention.

Preferably the two conversion circuits are responsive to timing signals derived from common clock generation means which is responsive to incoming bit rate clock signals and incoming frame synchronisation signals to generate such timing signals.

A signal conversion circuit in accordance with the invention will now be described by way of example only with reference to the accompanying drawings of which:-

Figure 1 is a diagram of the principle blocks of the circuit;

Figure 2 is a block schematic diagram of the common circuit block of Figure 1;

Figures 3A, B and C form a block schematic diagram of the linear to A-law encoding circuit block of Figure 1;

Figures 4A, B and C form a block schematic diagram of the A-law to linear encoding circuit block of Figure 1;

Figure 5 is a timing diagram relating to the circuit of Figure 2;

Figure 6 is a timing diagram relating to the circuit of Figures 3A, B and C;

Figure 7 is a timing diagram relating to the circuit of Figures 4A, B and C; and

Tables 1 and 2 show, respectively, coding arrangements for linear to A-law conversion and A-law to linear conversion.

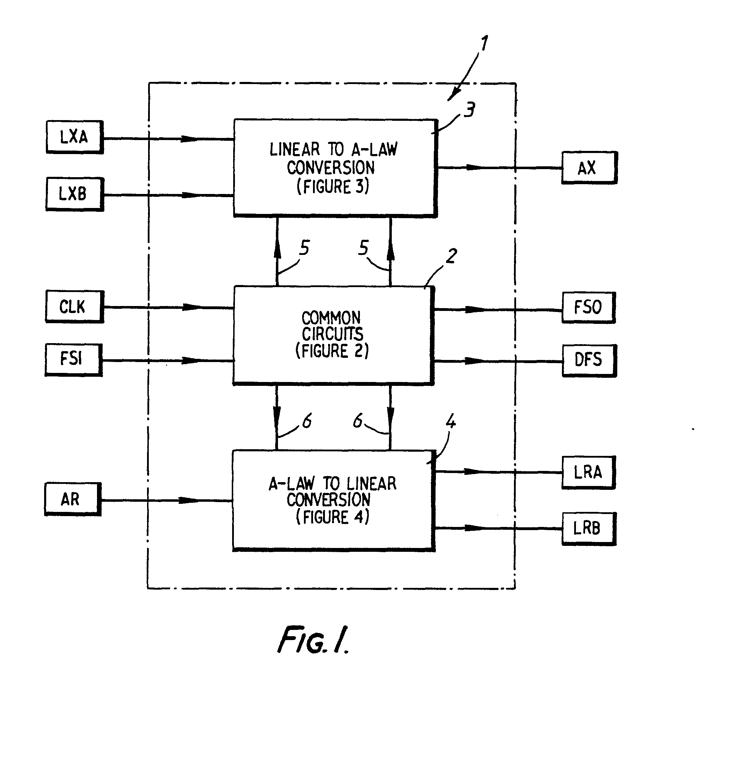

Referring to Figure 1 the signal conversion circuit 1 may conveniently be considered as three separate circuit blocks namely common circuits 1 which provides timing functions to the other blocks namely a linear to A-law conversion block 3 and an A-law to linear conversion block 4.

The common circuits 2 receive a two megahertz clock signal (CLK) and an eight kilohertz frame synchronisation signal (FSI) and outputs a frame synchronisation signal (FSO) and a delayed frame synchronisation signal (DFS). The common circuits 2 also provide a series of timing signals to the conversion blocks 3 and 4 by way of respective highways 5 and 6.

The linear to A-law conversion circuit 3 receives two streams of linear encoded 16-bit data - (LXA and LXB) and outputs a single 32-channel A-law encoded bit stream (AX).

Similarly the A-law to linear conversion circuit 4 receives a single 32-channel A-law encoded bit stream (AR) and outputs two streams of linear encoded 16-bit data (LRA and LRB).

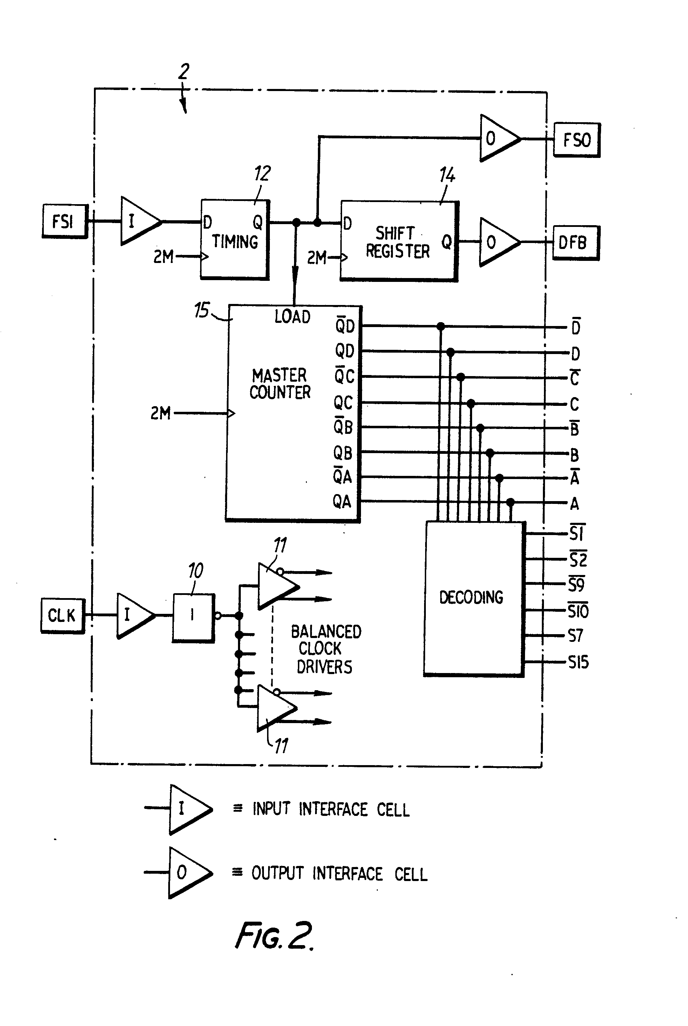

Turning now to Figure 2, the two megahertz clock signal (CLK) is fed to a high powered inverter 10 to eighteen clock drivers 11 which provide the required two phase clock signal required by D type flip flop cells used in the conversion circuits 3 and 4 and by other cells in the common circuits 2.

For simplicity the two phase clocking of D type cells is not shown in the diagrams nor are the interconnections between the clock drivers 11 and these cells. For the avoidance of doubt a single clock input labelled "2M" is shown on all cells on an unmarked lead for cells triggered on a positive going edge and on a lead marked with a logic inversion symbol (o) for cells triggered on a negative going edge.

The frame synchronisation signal (FSI) is retimed by a flip flop 12 to a rising edge of CLK. This signal then passes directly to the output as FSO and to the input of a shift register 14 to provide DFS eight clock periods later than FSO.

The FSO signal also causes a master counter 15 which comprises four D type flip flop elements with feedback gating for up-counting to load "1011" on to the 'D' inputs of the elements to synchronize the counter to external data highways. From the A to D and $\overline{A}$ to $\overline{D}$ outputs of the master counter 15, decode gating 16 generates six timing signals each one clock period wide. These timing signals comprise four active "low" signals S1, S2, S9 and S10 and two active high signals S7 and S15.

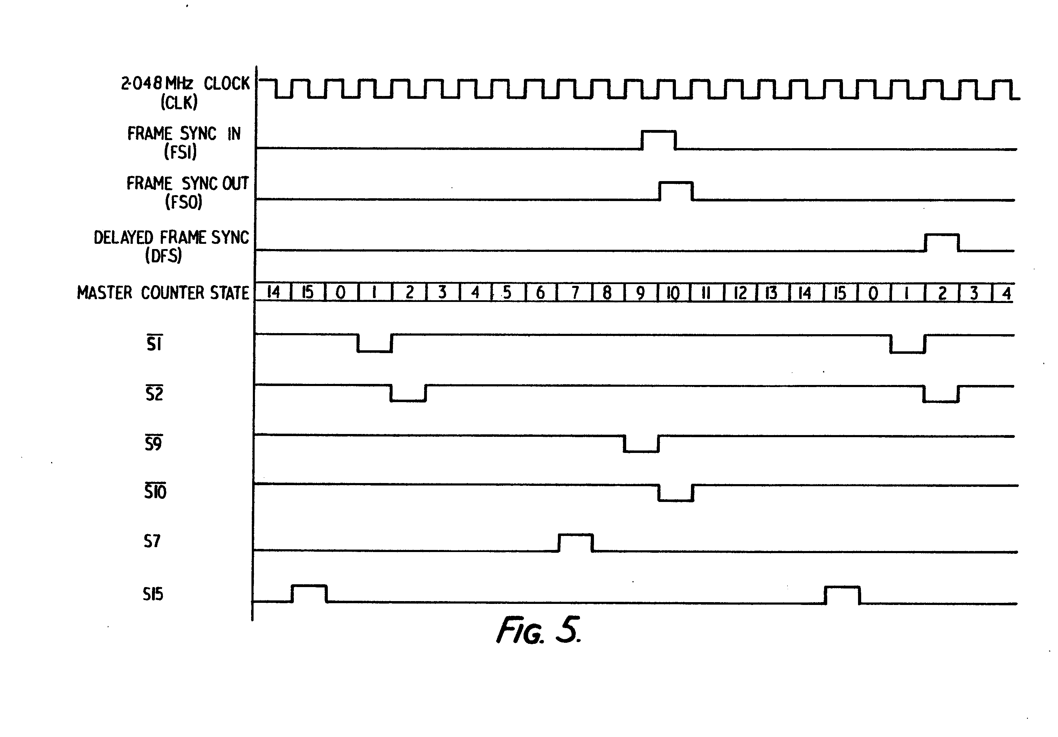

Figure 5 shows the relative timing of the signals in the common circuit 2 in relation to FSO, CLK and the master counter (15) count.

The linear to A-law conversion circuitry 3 receives the LXA and LXB data streams each of which comprises sixteen linear encoded TDM channels and converts these two streams into a thirty two channel A-law encoded data stream.

Thus referring to Figures 2A, B and C LXA and LXB are received by two identical circuits 30, 30' Since the two circuits 30, 30' are identical the description hereinafter relates to the processing of LXA insofaras the processing of LXA and LXB are identical, corresponding parts of the circuit 30' being identified where necessary in the text by the addition of a prime mark to the designations used in the circuit 30.

Before discussing the operation of the circuit 30 in detail it is useful to consider Table 1 which shows the conversion functions necessary to achieve A-law encoding from linear coding by way of an intermediate code. Note that the A-law code has alternate bits of the intermediate code inverted.

The intermediate code comprising a sign bit - (SB) three chord bits (C2-C0) and four step bits - (S3-S0) has its sign bit (SB) inverse to the first bit of the linear code (L0). The three chord bits (C2-C0) are binary seven less the number of leading bits in the linear code (L1-L7) before a binary inversion occurs whilst the step bits (S3-S0) are derived from the four bits selected from (L2-L11) immediately following the inversion except where L1-L7 do not include an inversion in which case L8-L11 are selected. L12-L15 are ignored.

It will be appreciated that negative linear codes are the one's complement of corresponding positive linear codes, thus by inverting the bits of the negative linear codes both polarities may be processed in exactly the same way.

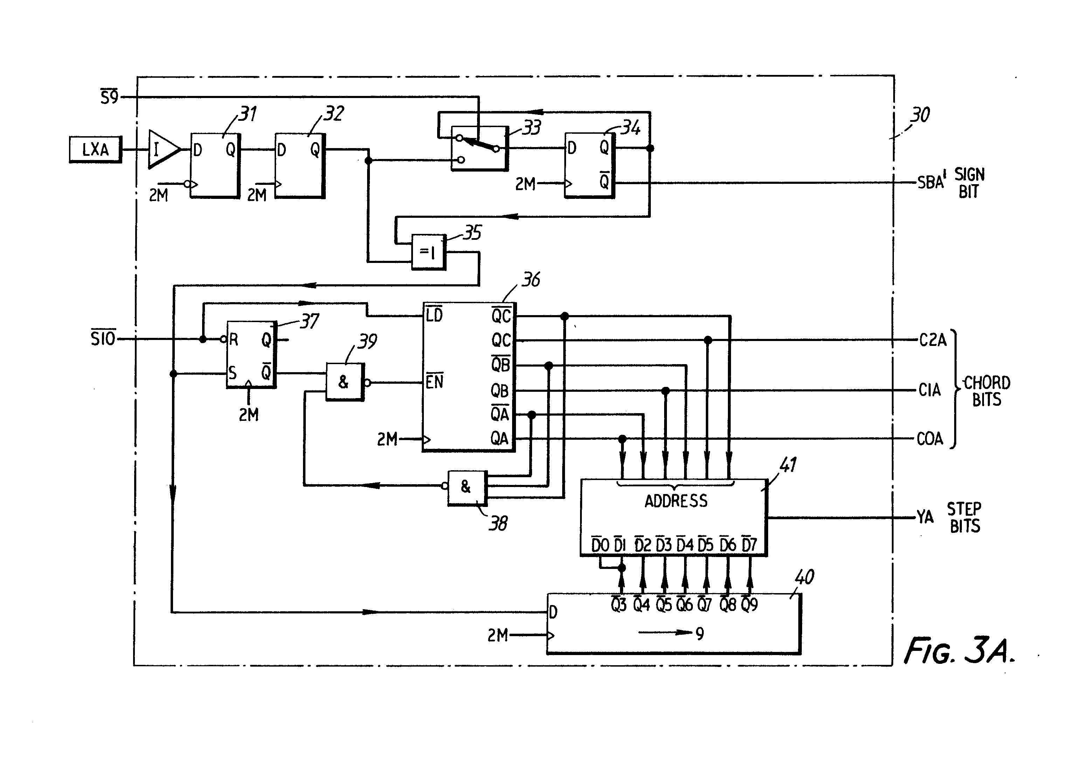

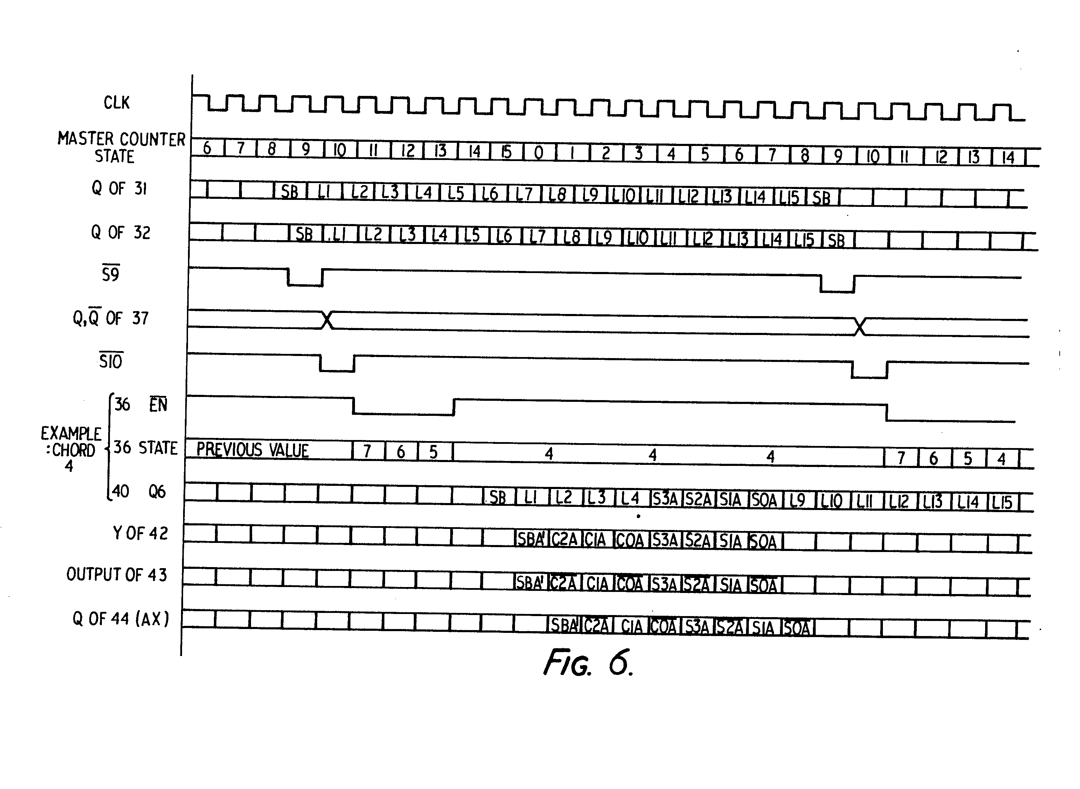

Now referring again to Figure 3A and to the related timing diagram of Figure 6, the incoming data stream LXA is received on an input of a D type flip flop 31 triggered on the negative going edge of the control clock. The bit stream is then retimed to the next positive going edge of the control clock by a further D type flip flop 32 to align the bit stream with the master counter (15 of Figure 2). When the master count reaches nine - (1011) as set by the FSI signal S9 causes a transmission gate 33 to switch to cause the first bit of the linear code (LO) to set or reset a flip flop 34. The flip flop 34 now locks to that state until the next occurrence of S9 and outputs the inverse of LO as the sign bit (SB) of the intermediate code since the transmission gate 33 connects the Q output of the flip flop 34 to its input.

The Q output is also fed to one input of a comparator gate 35 which receives the incoming data stream LXA (as retimed) on its other input. Thus, if LO indicates that a negative word is received the remaining bits are inverted, whilst if LO indicates a positive word the gate 35 appears transparent to the data stream.

This allows the remainder of the circuit 30 to handle positive and negative words of LXA in an identical manner.

On receipt of the next bit (L1), $\overline{S1O}$ (from the master counter 15 and decoder of Figure 2) causes seven (binary 111) to be loaded to a down counter 36. $\overline{S1O}$ also causes a bistable circuit 37 (which is a clocked NOR type R-S flip flop) to reset. The circuit 37 is now ready to be set by the first binary one received on its other input from the gate 35. $\overline{Q}$ of the circuit 37 now enables the down counter 37 to count down until the first 'one' present in LXA (or LXA inverted for negative words).

The exemplary timing in Figure 6 is presented for a linear word selected from chord 4 of Table 1 thus L1, L2 and L3 do not cause the bistable 37 to reset and the counter 36 counts down on clocking to four ("100") before being disabled by the change in $\overline{Q}$ of circuit 37. The output of the counter 36 accordingly provides chord bits C2-C0 in accordance with the linear to intermediate code conversion of Table 1 except that in respect of chord zero, the counter could reset to 'seven'.

To ensure that the counter 36 stops when C2-C0 read binary zero, outputs $\overline{QC}$, $\overline{QB}$ and $\overline{QA}$ of the counter 36 are gated together through a NAND gate 38 and then with $\overline{Q}$ of

bistable 37 in a NAND gate 39 to stop the counter 36 once chord zero is reached. The value set in the counter 36 now remains constant until the next occurrance of $S1O$.

To generate the step bits (S3-S0) of the intermediate code LXA or $\overline{LXA}$ also passes to the input of a shift register 40 stepped by the control clock.The outputs $\overline{Q3}$ to $\overline{Q9}$ of the shift register 40 provide data to the data inputs of a data selector 41 which is addressed by the counter 36 using the chord bits C2-C0. Thus since the address is determined, the step bits, the next four bits of of the linear code, pass from LXA through the shift register 40 and the data selector 41 to provide an output on YA.

Consider then a linear word in chord 4, L0 provides the sign bit, the counter 36 counts down from seven to four in the three clock cycles at which L1, L2 and L3 are present. D4 of the data selector 41 is thus addressed to output the bits present on Q6 of the shift register 40 namely L5 to L8 in sequence at counts four to seven of the master counter 15 these being step bits S3-S0 respectively.

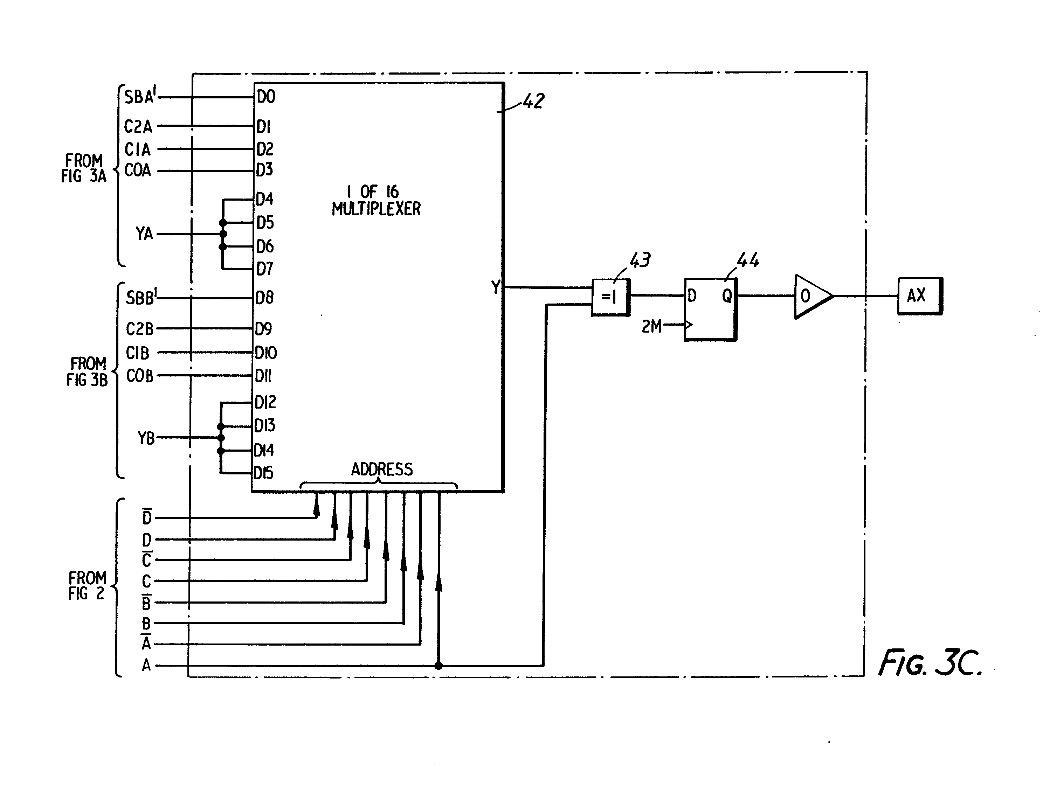

Now referring also to Figure 3C the two data streams derived from IXA and IXB respectively are passed to the input of a one from sixteen multiplexer 42 which is addressed by the master counter 15 of Figure 2 to select on the sixteen steps, the sign bit from the bistable 34, the chord bits from the counter 36, the four step bits from the shift register 40 through the data selection 41 then the sign bit from the bistable 34', the chord bits from the counter 36' and four step bits from the shift register 40' to combine into one 16 bit channel output at Y comprising two eight bit intermediate code channels per frame.

It is now necessary for alternate bits of the intermediate code to be inverted to provide the A-law code output AX. This is achieved by gating the output at Y with output 'A' of the counter 15 which provides alternate binary one and zero inputs to a gate 43. The output of gate 43 is retimed by a bistable circuit 44.

Thus sixteen input TDM channels LXA and sixteen input TDM channels LXB each of sixteen bit linear ·encoded PCM are output as thirty two TDM channels each of eight bit A-law encoded pcm.

It will be noted that the circuit 30' is clocked by S1 and $\overline{S2}$ that is eight clock pulses apart from the clocking of the circuit 30.

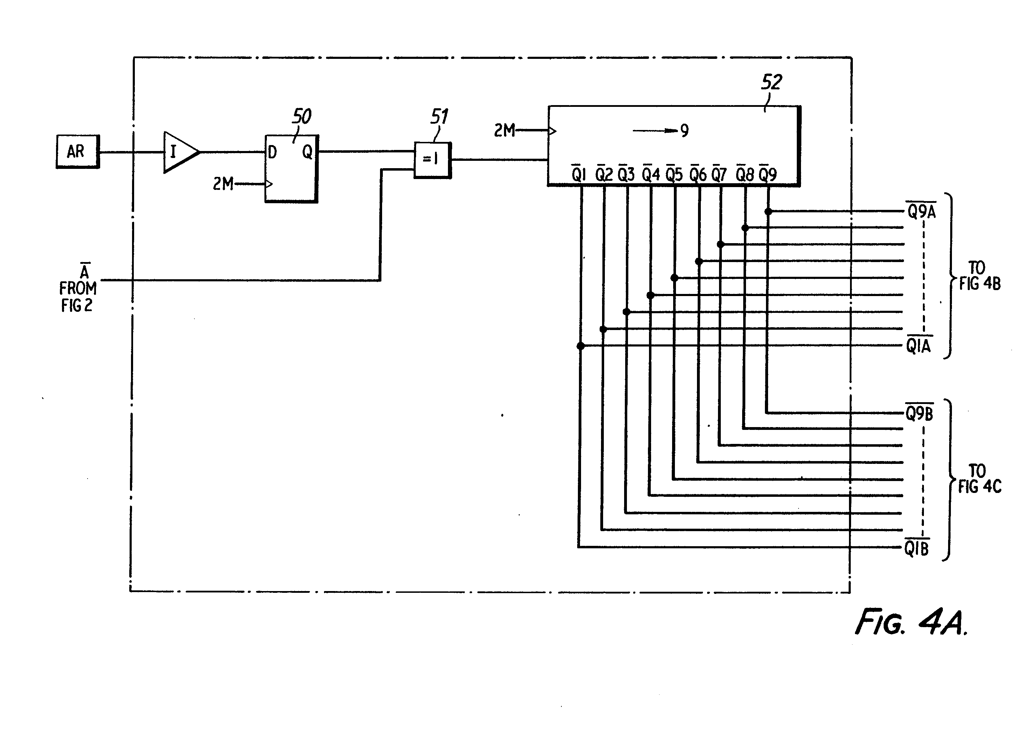

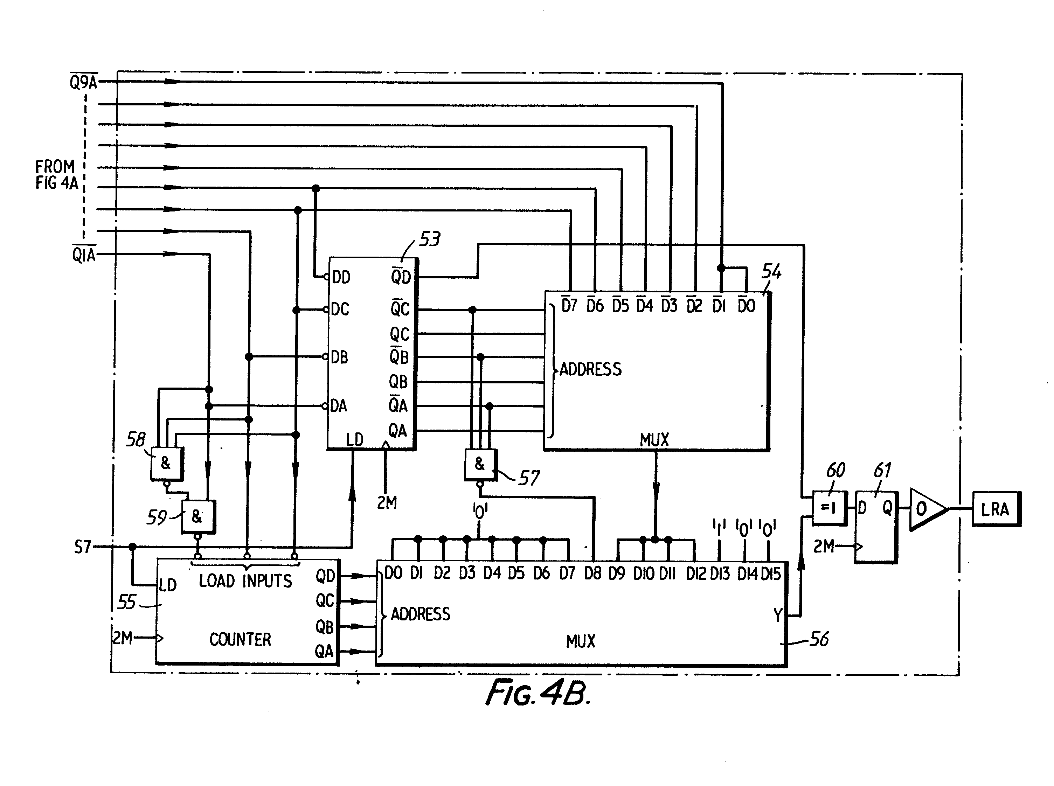

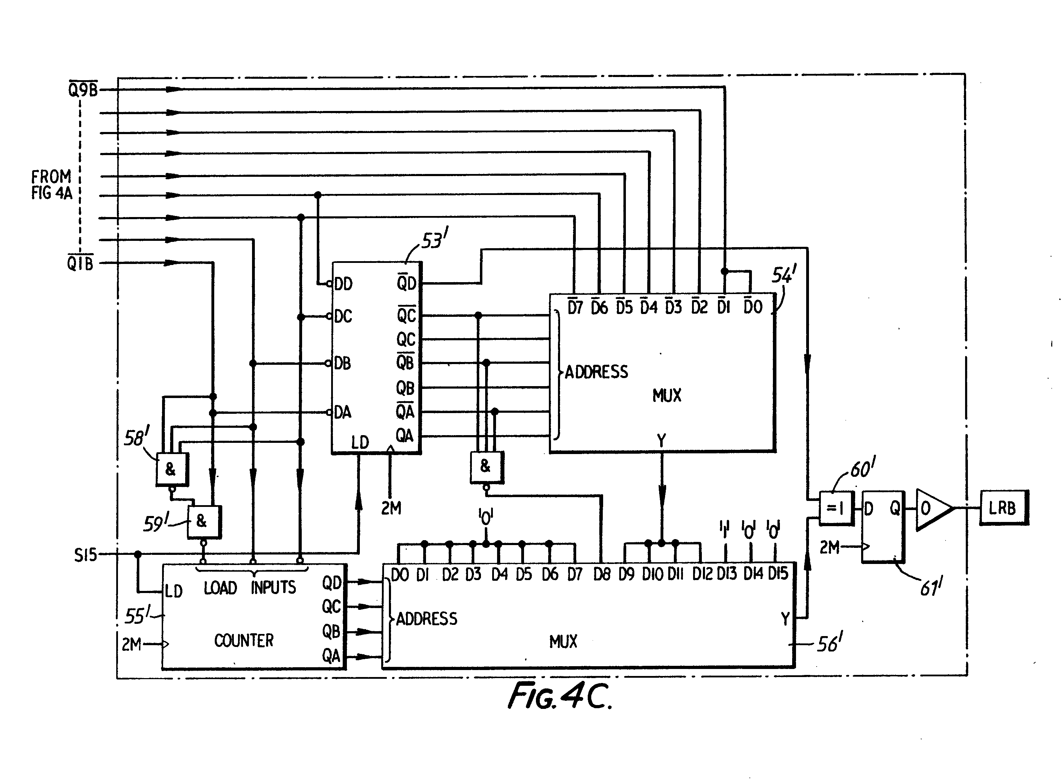

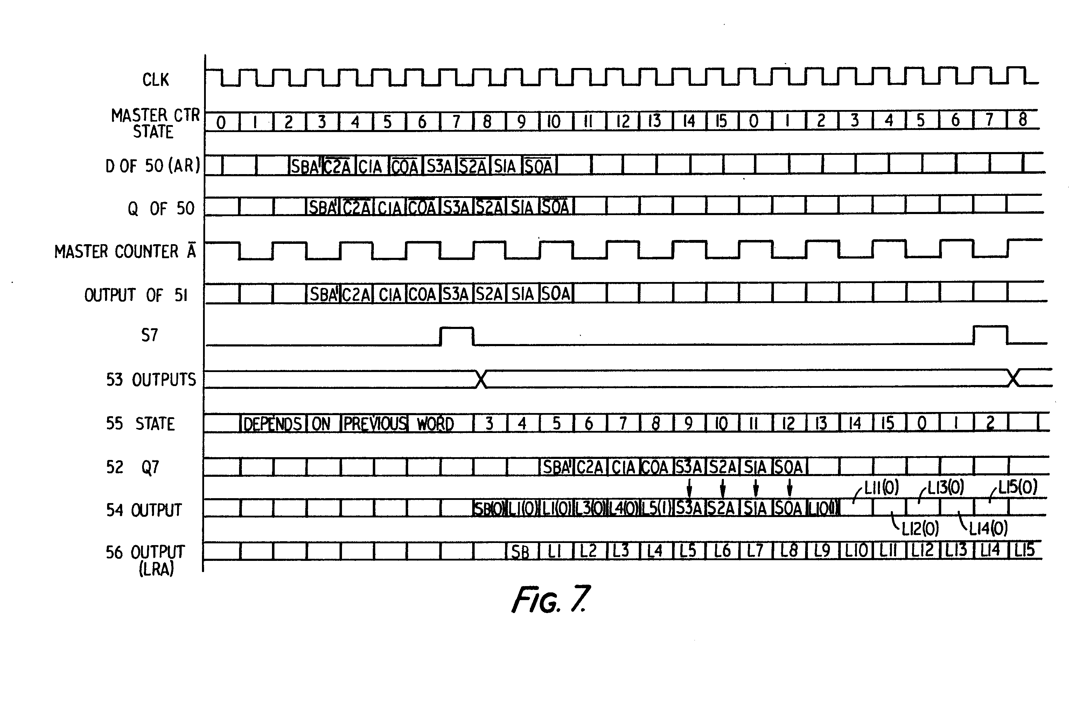

Referring now to Figures 4A, B and C the timing diagram of Figure 7 and Table 2, the A-law to linear conversion block (4 of Figure 1) converts the thirty two channel A-law encoded tdm data stream AR into two sixteen channel linear encoded tdm data streams LRA and LRB.

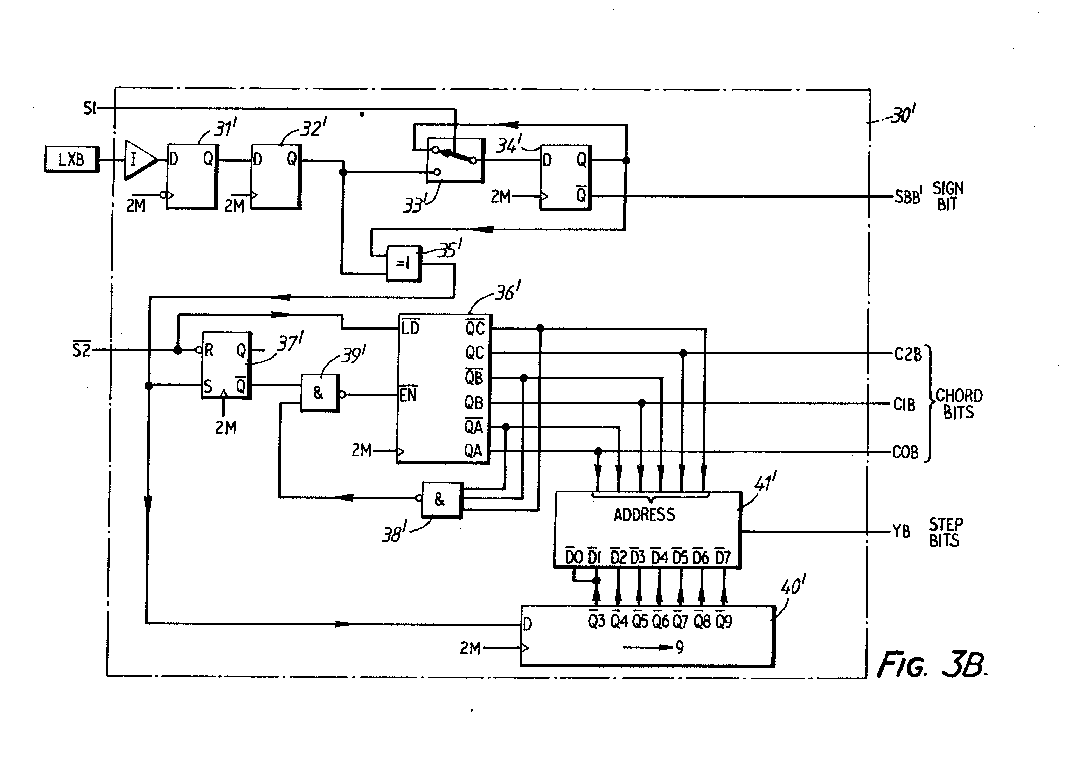

As with the linear to A-law encoded converter 3, the A-law to linear encoder 4 has some circuitry in common usage (Figure 4A) for initial processing of the A-law encoded data AR and two identical circuits (Figure 4B and 4C) for producing independant linear encoded data LRA and LRB. Processing of the LRA bit stream will be discussed in detail herein with reference to Figure 4B and corresponding elements for the LRB bit stream of Figure 4C will be identified by the same designation modified by a prime symbol ('). As with the circuit of Figure 3 common processing of both positive and negative words is employed as far as possible.

As may be seen from table 2 the generated linear code comprises a number of leading '0's (positive words) or '1's (negative words) identifying the chord which varies from one in the case of chord seven to seven in the cases of chords zero and one. The chord bits are followed by an inverse value bit except in the case of chord zero this prefix bit being followed by the four step bits (S3-S0).

Figure 4A to which reference to now made receives AR on a bistable circuit 50 which retimes the bit stream AR to the rising edge of the two megahertz clock signal. AR is now EX ORed in a gate 51 with the A output of the master counter (15 of Figure 2) to effect inversion of alternate bits of the A-law encoded data prior to application of the data stream to a shift register 52.

The outputs of each stage Q1-Q9 from the shift register 52 are now applied to the independant circuits of Figures 4B and 4C for the LRA and LRB bit stream generation respectively. Taking the LRA bit stream, when S7 from the master counter decode (15) is present the inverse of the sign bit - (SB) and the inverse of the chord bits (C2-C0) are present on outputs Q4, Q3, Q2 and Q1 respectively of the shift register 52 and are loaded to a counter 55 and a register 53 by way of an inversion.

It will be noted that the value of the count loaded to counter 55 is modified to "001" for chord zero values by the action of AND gates 58 and 59 meeting the leading zero requirement.

The counter 55 is a cyclic counter which returns to zero (0000) after count fifteen (1111) and addresses a multiplexer 56 which has 'zero' wired to addresses zero to seven, fourteen and fifteen, 'one' wired to address thirteen, and a NAND gate 57 output wired to address eight. The NAND gate 57 generates the prefix bit which is zero for chord zero and one for all other chords by combining the $\overline{Q A}$ to $\overline{Q C}$ outputs of the register 53.

The step bits are selected from AR by a multiplexer 54 addressed by the register 53 outputs which select one of eight inputs for output to addresses D9 to D12 of the multiplexer 56.

Taking a specific example of say a word in positive chord three, on S7 '1011' is loaded to register 53 and '011' to counter 55. Thus on succeeding clock pulses from the two megahertz clock the multiplexer 56 produces the following output sequences:-

| Pulse No | Count | Address | Output |
|----------|-------|---------|--------|
| 57 | 3 | D3 | 0 |
| 8 | 4 | D4 | 0 |
| 9 | 5 | D5 | 0 |
| 10 | 6 | D6 | 0 |
| 11 | 7 | D7 | 0 |
| 12 | 8 | D8 | 1 |
| 13 | 9 | D9 | S1 |
| 14 | 10 | D10 | S2 |
| 15 | 11 | D11 | S3 |
| 0 | 12 | D12 | S4 |
| 1 | 13 | D13 | 1 |
| 2 | 14 | D14 | 0 |
| 3 | 15 | D15 | 0 |
| 4 | 0 | D0 | 0 |
| 5 | 1 | D1 | 0 |
| 6 | 2 | D2 | 0 |

Note that at the appropriate counter state the required output from the shift register 52 is Q7 which is connected to the D3 input of the multiplexer 54 to provide the required step bits at addresses D9-D12 of the multiplexer 56. Note that the timing diagram (Figure 7) is based on a positive chord three input/output.

Finally, the output stream from the multiplexer 56 is EX ORed with the sign bit from output QD of the register 53 in a gate 60 to effect inversion of the output data stream for negative words, the gate 60 appearing transparent to the data stream for positive words. A bistable circuit 61 retimes the data to the rising edge of the two megahertz clock for output to LRA.

The sequence for generating LRB is identical to that outlined above except that loading of the register 53' and the counter 55' occurs at S15 (ie. eight clock pulses later than the loading of the register 53 and the counter 55), thus producing the required two sixteen channel, sixteen bit linear encoded pcm tdm output streams LRA and CRB from the thirty two channel eight bit A-law encoded pcm tdm input stream AR.

| CHORD | LO | LI | L2 | L3 | L4 | L5 | L6 | L7 | L8 | L9 | LIO | LII | LI2-I5 | SB | C2 | CI | CO | C3 | C2 | CI | CO | AO | AI | A2 | A3 | A4 | A5 | A6 | A7 |
|---|---|---|---|---|---|---|---|---|---|---|---|---|---|---|---|---|---|---|---|---|---|---|---|---|---|---|---|---|---|
| | LINEAR CODE | | | | | | | | | | | | | INTERMEDIATE CODE | | | | | | | | A-LAW CODE | | | | | | | |
| 7 | 0 | I | S3 | S2 | SI | SO | X | X | X | X | X | X | X | I | I | I | I | S3 | S2 | SI | SO | I | 0 | I | 0 | S3 | $\overline{S2}$ | SI | $\overline{S0}$ |
| 6 | 0 | 0 | I | S3 | S2 | SI | SO | X | X | X | X | X | X | I | I | I | 0 | S3 | S2 | SI | SO | I | 0 | I | I | S3 | $\overline{S2}$ | SI | $\overline{S0}$ |
| 5 | 0 | 0 | 0 | I | S3 | S2 | SI | SO | X | X | X | X | X | I | I | 0 | I | S3 | S2 | SI | SO | I | 0 | 0 | 0 | S3 | $\overline{S2}$ | SI | $\overline{S0}$ |
| 4 | 0 | 0 | 0 | 0 | I | S3 | S2 | SI | SO | X | X | X | X | I | I | 0 | 0 | S3 | S2 | SI | SO | I | 0 | 0 | I | S3 | $\overline{S2}$ | SI | $\overline{S0}$ |
| 3 | 0 | 0 | 0 | 0 | 0 | I | S3 | S2 | SI | SO | X | X | X | I | 0, | I | I | S3 | S2 | SI | SO | I | I | I | 0 | S3 | $\overline{S2}$ | SI | $\overline{S0}$ |
| 2 | 0 | 0 | 0 | 0 | 0 | 0 | I | S3 | S2 | SI | SO | X | X | I | 0 | I | 0 | S3 | S2 | SI | SO | I | I | I | I | S3 | $\overline{S2}$ | SI | $\overline{S0}$ |
| I | 0 | 0 | 0 | 0 | 0 | 0 | 0 | I | S3 | S2 | SI | SO | X | I | 0 | 0 | I | S3 | S2 | SI | SO | I | I | 0 | 0 | S3 | $\overline{S2}$ | SI | $\overline{S0}$ |
| 0 | 0 | 0 | 0 | 0 | 0 | 0 | 0 | 0 | S3 | S2 | SI | SO | X | I | 0 | 0 | 0 | S3 | S2 | SI | SO | I | I | 0 | I | S3 | $\overline{S2}$ | SI | $\overline{S0}$ |
| 0 | I | I | I | I | I | I | I | I | $\overline{S3}$ | $\overline{S2}$ | $\overline{SI}$ | $\overline{S0}$ | X | 0 | 0 | 0 | 0 | S3 | S2 | SI | SO | 0 | I | 0 | I | S3 | $\overline{S2}$ | SI | $\overline{S0}$ |
| I | I | I | I | I | I | I | I | 0 | $\overline{S3}$ | $\overline{S2}$ | $\overline{SI}$ | $\overline{S0}$ | X | 0 | 0 | 0 | I | S3 | S2 | SI | SO | 0 | I | 0 | 0 | S3 | $\overline{S2}$ | SI | $\overline{S0}$ |
| 2 | I | I | I | I | I. | I | 0 | $\overline{S3}$ | $\overline{S2}$ | $\overline{SI}$ | $\overline{S0}$ | X | X | 0 | 0 | I | 0 | S3 | S2 | SI | SO | 0 | I | I | I | S3 | $\overline{S2}$ | SI | $\overline{S0}$ |
| 3 | I | I | I | I | I | 0 | $\overline{S3}$ | $\overline{S2}$ | $\overline{SI}$ | $\overline{S0}$ | X | X | X | 0 | 0 | I | I | S3 | S2 | SI | SO | 0 | I | I | 0 | S3 | $\overline{S2}$ | SI | $\overline{S0}$ |
| 4 | I | I | I | I | 0 | $\overline{S3}$ | $\overline{S2}$ | $\overline{SI}$ | $\overline{S0}$ | X | X | X | X | 0 | I | 0 | 0 | S3 | S2 | SI | SO | 0 | 0 | 0 | I | S3 | $\overline{S2}$ | SI | $\overline{S0}$ |
| 5 | I | I | I | 0 | $\overline{S3}$ | $\overline{S2}$ | $\overline{SI}$ | $\overline{S0}$ | X | X | X | X | X | 0 | I | 0 | I | S3 | S2 | SI | SO | 0 | 0 | 0 | 0 | S3 | $\overline{S2}$ | SI | $\overline{S0}$ |
| 6 | I | I | 0 | $\overline{S3}$ | $\overline{S2}$ | $\overline{SI}$ | $\overline{S0}$ | X | X | X | X | X | X | 0 | I | I | 0 | S3 | S2 | SI | SO | 0 | 0 | I | I | S3 | $\overline{S2}$ | SI | $\overline{S0}$ |
| 7 | I | 0 | $\overline{S3}$ | $\overline{S2}$ | $\overline{SI}$ | $\overline{S0}$ | X | X | X | X | X | X | X | 0 | I | I | I | S3 | S2 | SI | SO | 0 | 0 | I | 0 | S3 | $\overline{S2}$ | SI | $\overline{S0}$ |

*TABLE 1: LINEAR TO A-LAW CONVERSION*

|  | A-LAW CODE | | | | | | | | INTERMEDIATE CODE | | | | | | | | LINEAR CODE | | | | | | | | | | | | | |
| CHORD | AO | AI | A2 | A3 | A4 | A5 | A6 | A7 | SB | C2 | CI | CO | S3 | S2 | SI | SO | LO | LI | L2 | L3 | L4 | L5 | L6 | L7 | L8 | L9 | LIO | LII | LI2 | LI3–I5 |
|---|---|---|---|---|---|---|---|---|---|---|---|---|---|---|---|---|---|---|---|---|---|---|---|---|---|---|---|---|---|---|
| 7 | I | 0 | I | 0 | S3 | $\overline{S2}$ | SI | $\overline{SO}$ | I | I | I | I | S3 | S2 | SI | SO | 0 | I | S3 | S2 | SI | SO | I | 0 | 0 | 0 | 0 | 0 | 0 | 0 |
| 6 | I | 0 | I | I | S3 | $\overline{S2}$ | SI | $\overline{SO}$ | I | I | I | 0 | S3 | S2 | SI | SO | 0 | 0 | I | S3 | S2 | SI | SO | I | 0 | 0 | 0 | 0 | 0 | 0 |
| 5 | I | 0 | 0 | 0 | S3 | $\overline{S2}$ | SI | $\overline{SO}$ | I | I | 0 | I | S3 | S2 | SI | SO | 0 | 0 | 0 | I | S3 | S2 | SI | SO | I | 0 | 0 | 0 | 0 | 0 |
| 4 | I | 0 | 0 | I | S3 | $\overline{S2}$ | SI | $\overline{SO}$ | I | I | 0 | 0 | S3 | S2 | SI | SO | 0 | 0 | 0 | 0 | I | S3 | S2 | SI | SO | I | 0 | 0 | 0 | 0 |
| 3 | I | I | I | 0 | S3 | $\overline{S2}$ | SI | $\overline{SO}$ | I | 0 | I | I | S3 | S2 | SI | SO | 0 | 0 | 0 | 0 | 0 | I | S3 | S2 | SI | SO | I | 0 | 0 | 0 |
| 2 | I | I | I | I | S3 | $\overline{S2}$ | SI | $\overline{SO}$ | I | 0 | I | 0 | S3 | S2 | SI | SO | 0 | 0 | 0 | 0 | 0 | 0 | I | S3 | S2 | SI | SO | I | 0 | 0 |
| I | I | I | 0 | 0 | S3 | $\overline{S2}$ | SI | $\overline{SO}$ | I | 0 | 0 | I | S3 | S2 | SI | SO | 0 | 0 | 0 | 0 | 0 | 0 | 0 | I | S3 | S2 | SI | SO | I | 0 |
| 0 | I | I | 0 | I | S3 | $\overline{S2}$ | SI | $\overline{SO}$ | I | 0 | 0 | 0 | S3 | S2 | SI | SO | 0 | 0 | 0 | 0 | 0 | 0 | 0 | 0 | S3 | S2 | SI | SO | I | 0 |
| 0 | 0 | I | 0 | I | S3 | $\overline{S2}$ | SI | $\overline{SO}$ | 0 | 0 | 0 | 0 | S3 | S2 | SI | SO | I | I | I | I | I | I | I | I | $\overline{S3}$ | $\overline{S2}$ | $\overline{SI}$ | $\overline{SO}$ | 0 | I |
| I | 0 | I | 0 | 0 | S3 | $\overline{S2}$ | SI | $\overline{SO}$ | 0 | 0 | 0 | I | S3 | S2 | SI | SO | I | I | I | I | I | I | I | 0 | $\overline{S3}$ | $\overline{S2}$ | $\overline{SI}$ | $\overline{SO}$ | 0 | I |
| 2 | 0 | I | I | I | S3 | $\overline{S2}$ | SI | $\overline{SO}$ | 0 | 0 | I | 0 | S3 | S2 | SI | SO | I | I | I | I | I | I | 0 | $\overline{S3}$ | $\overline{S2}$ | $\overline{SI}$ | $\overline{SO}$ | 0 | I | I |
| 3 | 0 | I | I | 0 | S3 | $\overline{S2}$ | SI | $\overline{SO}$ | 0 | 0 | I | I | S3 | S2 | SI | SO | I | I | I | I | I | 0 | $\overline{S3}$ | $\overline{S2}$ | $\overline{SI}$ | $\overline{SO}$ | 0 | I | I | I |
| 4 | 0 | 0 | 0 | I | S3 | $\overline{S2}$ | SI | $\overline{SO}$ | 0 | I | 0 | 0 | S3 | S2 | SI | SO | I | I | I | I | 0 | $\overline{S3}$ | $\overline{S2}$ | $\overline{SI}$ | $\overline{SO}$ | 0 | I | I | I | I |
| 5 | 0 | 0 | 0 | 0 | S3 | $\overline{S2}$ | SI | $\overline{SO}$ | 0 | I | 0 | I | S3 | S2 | SI | SO | I | I | I | 0 | $\overline{S3}$ | $\overline{S2}$ | $\overline{SI}$ | $\overline{SO}$ | 0 | I | I | I | I | I |
| 6 | 0 | 0 | I | I | S3 | $\overline{S2}$ | SI | $\overline{SO}$ | 0 | I | I | I | S3 | S2 | SI | SO | I | 0 | 0 | $\overline{S3}$ | $\overline{S2}$ | $\overline{SI}$ | $\overline{SO}$ | 0 | I | I | I | I | I | I |
| 7 | 0 | 0 | I | 0 | S3 | $\overline{S2}$ | SI | $\overline{SO}$ | 0 | I | I | I | S3 | S2 | SI | SO | I | 0 | $\overline{S3}$ | $\overline{S2}$ | $\overline{SI}$ | $\overline{SO}$ | 0 | I | I | I | I | I | I | I |

TABLE 2: A-LAW TO LINEAR CONVERSION

## Claims

1. A signal conversion circuit for converting an A-law encoded pcm-tdm data stream to two linear encoded pcm-tdm data streams the circuit comprising inversion means arranged to invert alternate bits of an incoming A-law encoded data stream to provide an intermediate encoded data stream having a sign bit, a plurality of chord bits characterising a chord number and a plurality of step bits, shift register means through which said intermediate encoded data stream is stepped at the bit rate, and a conversion circuit in respect of each linear encoded data stream which are respectively enabled on alternate frames of the incoming data stream and which each comprise storage means and counter means simultaneously enabled to set to the chord number received from predetermined outputs of the shift register means, the counter means counting at the bit rate to address multiplexing means to select for output in dependance upon the chord number and in respect of each frame at least one prefix bit of a first binary value, one bit of a value dependant upon the stored chord number, the plurality of step bits, a bit of the other binary value and a plurality of suffix bits of the first binary value, and inversion means responsive to the sign bit value to pass or invert the output of the multiplexing means.

2. A signal conversion circuit as claimed in claim 1, wherein each of the intermediate conversion circuits includes further multiplexing means which is addressed by said storage means to select one of the outputs of the shift register means in dependance upon the stored chord number to provide the plurality of step bits to inputs of the first said multiplexing means.

3. A signal conversion circuit as claimed in claim 1 or claim 2 in which said storage means also stores the sign bit received from another predetermined output of the shift register means, said stored sign bit causing said inversion means to pass or invert the output of the first said multiplexing means.

4. A signal conversion circuit for converting two linear encoded pcm-tdm data streams to a single A-law encoded pcm-tdm data stream the circuit comprising two encoders for converting respective linear encoded data streams to an intermediate encoded data stream, multiplexing means for selecting the outputs of the two encoders alternately to provide alternate frames of the output A-law encoded data stream and inversion means responsive to clock signals to invert alternate bits of the intermediate encoded data stream ot provide the A-law encoded data stream, each of said two encoders comprising means responsive to a frame synchronisation signal to store for each frame a sign bit from the incoming signal, inversion means responsive to the stored sign bit to invert or pass the incoming signal, counting means arranged to count the number of prefix bits present in the incoming signals and to provide a plurality of chord bits defining a chord number and selection means responsive to the chord number to select the plurality of bits following the prefix bits to output as step bits.

5. A signal conversion circuit as claimed in claim 4 in which said selection means comprises a shift register to which the incoming signal is applied, outputs of said shift register being connected to multiplexing means addressed by said chord number such that one output of said shift register provides the step bits of the first said multiplexing means.

6. A signal conversion circuit for converting an A-law encoded pcm-tdm data stream to two linear encoded pcm-tdm data streams and for converting two linear encoded pcm-tdm data streams to an A-law encoded data stream said circuit comprising a first signal conversion circuit in accordance with claim 1, claim 2 or claim 3 and a second signal conversion circuit in accordance with claim 4 or claim 5.

7. A signal conversion circuit as claimed in claim 6 further comprising clock generation means responsive to incoming bit rate clock signals and incoming frame synchronisation signals to generate timing signals which control said first and second signal.

FIG. 1.

0 211 673

FIG.2.

I ≡ INPUT INTERFACE CELL

O ≡ OUTPUT INTERFACE CELL

SBA SIGN BIT

CHORD BITS
C2A
C1A
C0A

STEP BITS
YA

LXA

S9

SIO

30

31  32  33  34  35  36  37  38  39  40  41

ADDRESS

D0 D1 D2 D3 D4 D5 D6 D7
Q3 Q4 Q5 Q6 Q7 Q8 Q9

9

QC QC QB QB QA QA

LD  EN

&

=1

2M

FIG. 3A.

SI

LXB

SBB' SIGN BIT

30'

31'

32'

34'

2M

33'

35'

=1

36'

QC
QC
QB
QB
QA
QA

LD

EN

2M

37'

R Q
S Q
2M

39'

&

38'

&

2M

S2

C2B

CIB

COB

} CHORD BITS

YB STEP BITS

41'

ADDRESS

D0 D1 D2 D3 D4 D5 D6 D7

40'

Q3 Q4 Q5 Q6 Q7 Q8 Q9

9

D

2M

*FIG. 3B.*

FROM FIG 3A

- SBA'
- C2A
- CIA
- COA
- YA

FROM FIG 3B

- SBB'
- C2B
- CIB
- COB
- YB

FROM FIG 2

- $\overline{D}$
- D
- $\overline{C}$
- C
- $\overline{B}$
- B
- $\overline{A}$
- A

1 OF 16 MULTIPLEXER — 42

D0, DI, D2, D3, D4, D5, D6, D7, D8, D9, DI0, DII, DI2, DI3, DI4, DI5

ADDRESS

Y — =1 (43) — D Q (44) — 2M — O — AX

FIG. 3C.

FIG. 4A.

0 211 673

FIG.4B.

*Fig. 4C.*

*Fig. 5.*

0 211 673

Fig. 6.

FIG. 7.

0 211 673